Europäisches Patentamt

European Patent Office

Office européen des brevets

(11) Publication number: **0 197 501**
A2

# (12) EUROPEAN PATENT APPLICATION

(21) Application number: **86104512.8**

(22) Date of filing: **02.04.86**

(51) Int. Cl.⁴: **H 01 L 29/08**
H 01 L 29/36, H 01 L 29/78
H 01 L 21/265, H 01 L 21/00

(30) Priority: **12.04.85 US 722641**

(43) Date of publication of application:
**15.10.86 Bulletin 86/42**

(84) Designated Contracting States:
**DE FR GB NL**

(71) Applicant: **GENERAL ELECTRIC COMPANY**
**1 River Road**
**Schenectady New York 12305(US)**

(72) Inventor: **Wei, Ching-Yeu**
**14 Sussex Way**
**Schenectady New York, 12309(US)**

(72) Inventor: **Pimbley, Joseph Maxwell**
**15 Cheshire Place**
**Schenectady New York, 12309(US)**

(74) Representative: **Catherine, Alain et al,**
**General Electric - Deutschland Munich Patent Operations**
**Frauenstrasse 32**
**D-8000 München 5(DE)**

(54) **Extended drain concept for reduced hot electron effect.**

(57) Hot electron injection into the gate oxides of MOSFET devices imposes limitations on the miniaturization of such devices in VLSI circuits. A buried channel is provided to guard against hot electron trapping effects while preserving process and structure compatibility with micron or submicron VLSI devices. The channel current is redirected into a buried channel at a distance away from the interface in the vicinity of the drain region where the hot electron effect is most likely to occur. This redirection is effected by providing a buried, lightly doped region extending inwardly from the conventional source and drain implant profile regions.

FIG. 1

# EXTENDED DRAIN CONCEPT FOR REDUCED HOT ELECTRON EFFECT

## ~~Background of the Invention~~

The present invention relates to field effect transistor devices and more particularly, to such devices containing differentially doped subsurface structures which provide reduced electric field strength levels at the interface boundary between the gate oxide and the semiconductor body.

One of the most useful and advantageous electrical device is the field effect transistor (FET). Very large scale integrated (VLSI) circuits have been created using metal-oxide-semiconductor (MOS) field effect devices. These so-called MOSFET devices take their name from the structure of the device in the vicinity of the gate. The gate electrode typically comprises a metal layer insulated by a silicon oxide layer from a doped semiconductor layer beneath the oxide. In the present invention, the problem addressed is the trapping of hot or energetic electrons in the gate oxide region, particularly in those regions adjacent to the device drain.

Decreased cost and improved performance provide an impetus for miniaturizing metal oxide semiconductor devices even further. Continuing advances in lithography and etching will permit even greater reductions in device size. Unfortunately, for reasons such as the compatibility with existing systems, power supply voltages used in such devices usually fail to decrease with increasing circuit density. As a result of this violation of ideal scaling, electric field strength levels within the device increase as geometric distances shrink. High field effects within MOS devices include carrier mobility reduction and channel hot electron instability in MOSFETs, particularly n-channel MOSFETS or, NMOSFETs. Electrons flowing from the source to drain regions of an n-channel FET gain energy from the lateral electric field component. This component of electric field is parallel to the interface between the silicon semiconductor and the silicon oxide insulating layer beneath the gate electrode. Energetic electrons tend to surmount the silicon/silicon-oxide energy barrier and are trapped within the oxide gate insulator or generate undesirable interface states by mechanisms which are not yet fully understood.

Hot or energetic electrons from the channel current have a tendency to acquire sufficient energy to surmount the barrier between the semiconductor and the gate oxide and as a result, are injected into the oxide. Subsequent trapping of the injected electrons tends to cause device instabilities such as threshold-voltage shift and transconductance degradation. Accordingly, it is highly desirable that hot-electron resistant MOSFETs be devised to prevent such instabilities. These instabilities impose undesirably severe limitations on the further miniaturization of MOSFET devices in VLSI circuits.

While improvements in hot electron effect problems can be partially effected by increasing the thickness of the gate oxide, this is an undesirable option because it reduces gate control effect, and results in slower operating devices.

It is seen that the hot electron problem is certainly undesirable and may eventually limit the minimum gate length for MOSFETs. Although improving the insulator quality with respect to hot electron trapping may be possible, most efforts at improving channel hot electron reliability have focused on reducing the lateral electric field strength within the FET channel. Such attempts include graded source/drain junctions, double-diffused source/drain regions, and an oxide sidewall spacer adjacent to the gate electrode and oxide. All of these methods reduce the lateral field strength by making the $n^+$-p drain-channel transition less abrupt. The instant inventors have found that the oxide sidewall spacer can increase the maximum safe operating voltage by as much as 2 volts. A maximum gain of 1.5 volts per 1,000 angstroms of spacer length is possible. It is additionally noted that any method or structure which is directed at relieving the hot electron effect problem should be compatible with present VLSI semiconductor processing steps.

## Summary of the Invention

In accordance with a preferred embodiment of the present invention, a buried spacer is employed so as to move high density current flow away from the silicon/silicon-oxide interface boundary. In particular, a lightly doped region is developed by ion implantation in source or drain regions (preferably both) on either side of the gate electrode by means of a high voltage field. Silicon oxide spacers on either side of the gate electrode are then formed by a process such as reactive ion etching, which is anisotropic. A second ion implantation operation is performed at an increased dopant concentration, but at a lower ion implant field strength. However, the higher dopant concentrations result in deeper semiconductor penetration. As a result of this process, more lightly doped regions extend from the source and drain regions beneath the semiconductor surface. It is between these two source and drain extensions that the highest current density is most likely achieved. This results in a reduction of hot electron production in the vicinity of the gate oxide. The lateral electric field strength, particularly the field strength immediately beneath the gate oxide, is significantly reduced.

Accordingly, it is an object of the present invention to provide a method for the manufacture of MOSFET devices exhibiting greater immunity to hot electron effects.

It is also an object of the present invention to provide improved NMOSFET manufacturing processes.

It is yet another object of the present invention to provide a means for reducing the lateral electrical field strength beneath the gate oxide in a MOSFET device.

It is a still further object of the present invention to provide a method for decreasing MOSFET circuit size without exacerbating hot electron effects.

Lastly, but not limited hereto, it is an object of the present invention to provide MOSFET, and in particular NMOSFET devices, in which hot electron effects are significantly mitigated.

Description of the Figures

The subject matter which is regarded as the invention is particularly pointed out and distinctly claimed in the concluding portion of the specification. The invention, however, both as to organization and method of practice, together with further objects and advantages thereof, may best be understood by reference to the following description taken in connection with the accompanying drawings in which:

Figure 1 is a cross-sectional side elevation view of a MOSFET device produced in accordance with the present invention;

Figure 2 is a computed plot of the lateral electric field at the semiconductor surface as a function of channel position for various source and drain implantation configurations including the buried drain concept of the present invention.

Detailed Description of the Invention

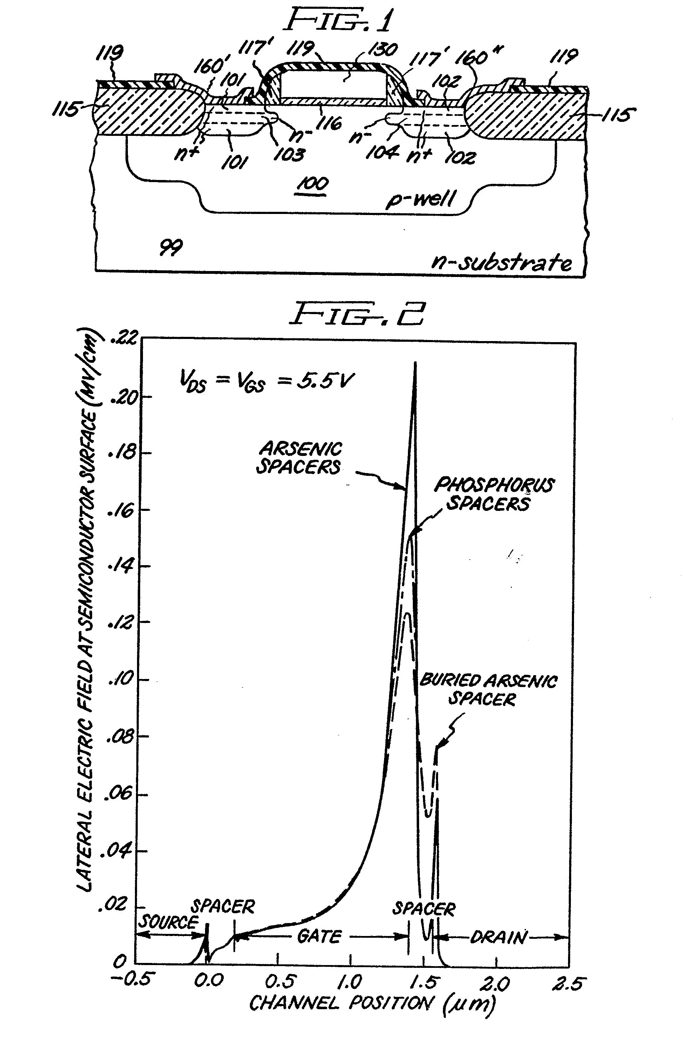

Figure 1 illustrates an NMOSFET device in accordance with the present invention. Except for the specific processing employed to carry out the purposes of the present invention, device fabrication is accomplished in the conventional fashion. Figure 1 particularly indicates an underlying n-doped substrate 99. In accordance with conventional processes, field oxide layer 115 is grown on substrate 99 by exposing the substrate to oxygen at a high temperature, so as to form an insulating layer of silicon oxide 115. This layer is etched in a patterned fashion to define active areas on the chip or wafer. A p-doped well 100 is typically thereafter formed by ion implantation through the active area openings in the field oxide. A thin silicon oxide layer is then grown over the entire substrate. This oxide layer ultimately forms gate oxide 116 which comprises the structure which is subject to the hot electron trapping effect discussed above. Over this thin oxide layer, a layer of polycrystalline silicon is deposited and heavily doped with an n-type dopant so as to provide a material exhibiting high electrical conductivity. This layer eventually forms gate electrode 130. Alternatively, metal rather than doped polycrystalline silicon may be employed for the gate electrode material. In any event, at this stage in the process, a mask is generally employed to produce gate electrode and electrode interconnection patterns where desired. These patterns are created by selective removal of the polycrystalline silicon or metal gate electrode material which typically leaves a thin oxide layer in the active area.

At this stage in the semiconductor manufacturing process, special process steps are employed to effect the formation of the structure illustrated in Figure 1. More particularly, at this point in the process, a light concentration of n-type dopant such as arsenic or phosphorous is deposited in a buried layer. This deposition occurs by means of ion implantation at a voltage of approximately 200 keV. This results in the formation of lightly doped regions 103 and 104 (between the dotted lines) at a depth of approximately 1,000 angstroms below the silicon/oxide interface. It should be noted that regions 103 and 104 extend from field oxide 115 inwardly to the left and right edges of gate electrode 130. This doping is performed at an implant dosage of approximately $10^{13}$ dopant atoms per square centimeter of source or drain region. In contrast, prior art doping process steps are carried out at much lower implantation voltages and do not produce the buried spacer effect described herein.

At this stage of the process, another silicon dioxide layer is deposited on the surface of the wafer or chip. However, in contrast to other methods for depositing an oxide layer, in this process step chemical vapor deposition is typically employed since it is desired to cover the entire surface of the device. A reactive ion etching step is then carried out, typically in an atmosphere of trifluoromethane ($CHF_3$) to anisotropically etch away most of this silicon layer except in those areas exhibiting sharp vertical transitions such as on either side of gate electrode 130. The anisotropic etching is advantageous in that it leaves oxide spacers 117' on either side of gate electrodes 130. These spacers provide an important function in mitigating the effects of hot electrons generated near the oxide/semiconductor interface below the gate and more particularly in the vicinity between the gate the device drain. Additionally, spacers 117' also provide a form of self aligned mask for the next process step which is the ion implantation or diffusion of the source and drain regions. In accordance with the present invention, a heavier, $n^+$, doping is applied to the source and drain regions of the active area. Typically, this second doping process step is performed at an implant dosage of about $8 \times 10^{15}$ dopant atoms per square centimeter. This results in the formation of regions 101 and 102 in Figure 1, these regions typically extending to a depth of between about 1,500 (450 mm) and 4,000 angstroms. (400 mm) Because of the masking effect produced by spacers 117', only a small $n^-$ doped region

of the source and drain is left to extend inwardly from regions 101 and 102. Typically each gate side spacer 117' is between about 0.1 and 0.2 micro*meter* in width. Accordingly, the lightly doped portions of the source and drain region extend inwardly toward the gate for a corresponding distance of between approximately 0.1 and 0.2 micro*meter*.

In accordance with the present invention, it is also possible to employ gate spacers 117' which comprise polysilicon material. In this embodiment, lightly doped regions 103 and 104 can be implanted at more conventional voltage levels, say for example, 90 kev. In this embodiment, buried channels are formed as the doped polysilicon or metal spacer is biased to a positive voltage via a doped polysilicon gate.

In the event that it is desired to employ doped polycrystalline silicon spacers, reactive ion etching is employed to effect removal of the polycrystalline silicon material in the gate masking portion of the process.

Figure 2 illustrates the relative improvement in the lateral electric field in the gate region achieved by the various spacer configurations. In particular, Figure 2 illustrates computer simulated variations in electric field strength as a function of channel position. The electrical field strength is measured in megavolts per centimeter and the channel position is given in microns. The figure also indicates the various device regions across the gate region of the semiconductor material in a MOSFET device. More particularly, the figure illustrates the variation from the source to the drain region through the gate region and includes spacers on either side of the gate electrode. In all cases shown, the source-to-drain voltage, and the source to gate voltage was fixed at 5.5 volts. In the event that conventional arsenic-doped spacers are employed at the surface of the semiconductor substrate, it is seen that the lateral field reaches a peak of approximately 0.21 megavolts per centimeter (MV/cm) in the vicinity between the gate and the drain. If conventional phosphorous doped surface spacers are employed, it is seen that the peak simulated electric field strength is reduced to approximately 0.15 megavolts per centimeter. However, in the preferred embodiment of the present invention, it is seen that a buried arsenic spacer, which is particularly illustrated in Figure 1, results in a maximum lateral electric field strength of only approximately 0.12 megavolts per centimeter. This reduction in lateral electric field strength is desirable for controlling the hot electron effect.

NMOSFETs of various channel lengths and widths in a boron-implanted p-doped semiconductor have been fabricated. The fabricated devices have included devices with and without oxide sidewall spacers. In conventional spacer fabrication, a light dose (typically $10^{12}$ to $10^{14}$ atoms per square centimeter) of n-type ion implantation follows the gate etching step. An oxide layer is then conformally deposited and anisotropically etched to leave a sidewall remnant at all sharp steps, specifically at the gate electrode. The gate and sidewall oxide then act as a self-aligned mask for the conventional heavy source/drain ion implant or diffusion. The buried spacer concepts presented herein differs from conventional spacer structures principally in the ion implant energy of the light implant. The buried spacer implant is performed at a voltage level of 200 keV while the conventional spacer and the source/drain were implanted at 90 keV.

The most direct assessment of the hot electron mitigation effect of the present invention is the measurement of device parameters before and after DC stress. Three device types were stressed for one hour with $V_{ds} = V_{gs} = 8V$. The first device, with no spacers, failed under these stress conditions. A second device with a conventional spacer, however, performed better in this test. However, it was observed that a third device, a buried spacer FET, suffered significantly less degradation in its linear transconductance parameter. Furthermore, inspection of the FET current voltage characteristics of this third device found no adverse consequences of the high energy spacer implant.

Accordingly, it is seen from the above that the methods and structure of the present invention provide a viable solution to the problem of hot electron entrapment in the oxide layer of a MOSFET device. It is also seen that the present invention provides a simplified process for producing the desired structural implant modification without departing from conventional processing methodologies. It is also seen that the present invention permits the shrinkage of MOSFET circuits to densities which are even greater than those currently achievable without the necessity of scaling down supply voltages. Accordingly, devices manufactured in accordance with the present invention are much more readily incorporated in currently existing systems. It is also seen that the devices of the present invention are much better able to undergo voltage stress without significant device characteristic impairment.  It is additionally noted that, while it is generally preferred that both the source and drain regions possess the buried channel structure of the present invention, it is possible to employ such a structure in only one of these regions.  However, in transistors in which current flow is unidirectional it is generally preferred to employ such structures only in the drain region.

~~While the invention has been described in~~ detail herein in accord with certain preferred embodiments thereof, many modifications and changes therein may be effected by those skilled in the art.  Accordingly, it is intended by the appended claims to cover all such modifications and changes as fall within the ~~true spirit and scope of the invention.~~

— CLAIMS—

1.  A metal oxide semiconductor field effect transistor comprising:

a semiconductor body doped with a first polarity dopant;

an insulating layer disposed over a portion of said body; and

an electrically conductive gate electrode disposed over said insulating layer so as to be electrically insulated from said semiconductor body;

said semiconductor body having a source region heavily doped with a second polarity dopant and a drain region heavily doped with said second polarity dopant, said source and drain regions being disposed in said semiconductor body to a specified depth on either side of said gate electrode; and

said semiconductor body also having a lightly doped protrusion extending from at least one of said source and drain regions, said light dopant being a second polarity dopant, said lightly doped protrusion being disposed beneath the surface of said semiconductor body and extending toward the region beneath said gate electrode, said lightly doped protrustion being spaced apart from the boundary between said semiconductor body and said insulating layer.

2.  The transistor of claim 1 in which a first lightly doped region portion extends from said source region and a second lightly doped region extends from said drain region.

3.  The transistor of claim 1 further including side spacers on either side of said gate electrode.

4. The transistor of claim 3 in which said spacers are between approximately 0.1 and 0.2 microns in width.

5. The transistor of claim 2 in which said lightly doped protrusions extend outwardly from adjacent heavily doped portions for a distance of between approximately 0.1 and 0.2 microns.

6. The transistor of claim 2 in which said lightly doped protrusions are disposed approximately 1,000 angstroms below the interface between said insulating layer and said semiconductor body.

7. The transistor of claim 1 in which said heavily doped regions extend approximately from the surface of said semiconductor body to a depth of between approximately 1,500 and 4,000 angstroms therein.

8. The transistor of claim 1 in which said first polarity dopant comprises a p-type dopant and said second polarity dopant comprises an n-type dopant.

9. The transistor of claim 1 in which said transistor is an n-channel device.

10. The transistor of claim 1 in which said second polarity dopant comprises material selected from the group consisting of arsenic and phosphorous.

11. The transistor of claim 1 in which said semiconductor body comprises silicon.

12. The transistor of claim 1 in which said semiconductor body comprises an n-doped semiconductor substrate including a p-doped well therein.

13. The transistor of claim 1 in which said insulating layer comprises silicon oxide.

14. The transistor of claim 1 in which said electrically conductive gate comprises material selected from the group consisting of metals and doped polycrystalline silicon.

15. The transistor of claim 1 in which said heavily doped region is formed at an implant dosage of approximately $8 \times 10^{15}$ atoms of dopant per square centimeter.

16. The transistor of claim 1 in which said lightly doped regions are formed at an implant dosage of between approximately $10^{12}$ and $10^{14}$ dopant atoms per square centimeter.

1/1

# FIG.1

# FIG.2

$V_{DS} = V_{GS} = 5.5V$

ARSENIC SPACERS

PHOSPHORUS SPACERS

BURIED ARSENIC SPACER

LATERAL ELECTRIC FIELD AT SEMICONDUCTOR SURFACE (MV/cm)

SOURCE    SPACER    GATE    SPACER    DRAIN

CHANNEL POSITION (μm)